# EUROPEAN PATENT APPLICATION

(11) **EP 2 020 680 A1**
(43) Date of publication of application: **04.02.2009**
(21) Application number: 07742231.9
(22) Date of filing: 24.04.2007
(51) Int. Cl.: H01L 21/304, B24B 37/00

(54) **POLISHING LIQUID FOR CMP AND METHOD OF POLISHING**

(30) Priority: 24.04.2006 JP 2006119086
(71) Applicant: Hitachi Chemical Company, Ltd., Tokyo 163-0449 (JP)
(72) Inventor: SHINODA, Takashi, Iberaki 317-8555 (JP); NOBE, Shigeru, Iberaki 317-8555 (JP); TANAKA, Takaaki, Iberaki 317-8555 (JP)
(74) Representative: HOFFMANN EITLE
(86) International application number: PCT/JP2007/058796
(87) International publication number: WO 2007/123235

(57) **Abstract**

A CMP polishing liquid being capable of using in a chemical mechanical polishing comprising of: a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and a second chemical mechanical polishing step of exposing the interlayer insulation film in the convex regions by polishing the barrier layer exposed in the first chemical mechanical polishing step; **characterized in that** a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1, 000 µm or more of the interlayer insulation film region formed on the substrate is polished to a depth of 400 Å or more .

## Description

### TECHNICAL FIELD

The present invention relates to a CMP polishing liquid and a polishing method.

### BACKGROUND ART

In the development for higher integration and higher performance of semiconductor integrated circuits (hereinafter, referred to as LSI's), recently new microfabrication methods have been developed. Chemical mechanical polishing (hereinafter, referred to as CMP) that is one of such metods is a technique used frequently in a process for manufacturing LSI, particularly for flattening of an interlayer insulation film, formation of a metal plug and formation of an embedded metal wiring in a process for forming a multilayer wiring, and is described in, for example, U.S. Patent No. 4,944,836.

For higher performance of LSI, it is recently attempted to use a copper or a copper alloy as the conductive substance for wiring material. However, the copper or copper alloy is hardly finely processable by dry-etching used frequently in forming a conventional aluminum alloy wiring.

Accordingly, a damascene process is mainly used in which a copper or a copper-alloy thin film is deposited and embedded on an insulating film having a groove previously formed thereon and then the thin film on a part other than the groove is removed by CMP, thereby forming an embedded wiring, and this damascene process is disclosed in, for example, Japanese Patent No. 1969537.

The general method of metal CMP for polishing a wiring metal such as copper or a copper alloy involves attaching a polishing pad onto a circular polishing platen, impregnating the surface of the polishing pad with a metal polishing liquid, pressing against the surface of the pad the side of a substrate on which a metallic film was formed, and rotating the polishing platen while applying a predetermined pressure (hereinafter referred to as polishing pressure) to the metallic film from the backside of the pad so as to remove a convex portion of the metallic film by the relative and mechanical friction between the polishing liquid and the convex portion of the metallic film.

A metal polishing liquid used in CMP comprises generally of an oxidizer, abrasive particles and water, and contains if necessary a metal oxide solubilizer, a protective film forming agent etc. In an estimated basic mechanism, the surface of a metallic film is first oxidized into an oxidized layer by the oxidizer , and then the oxidized layer is removed by the abrasive particles. The oxidized layer of the metallic film surface in a concave part is less likely to contact with the polishing pad and does thus not undergo abrasion with abrasive particles, while the oxidized layer of the metallic film in a convex part is removed with the progress of CMP, to flatten the surface of the substrate , the details of which are disclosed in Journal of Electrochemical Society, Vol. 138, No. 11, pp. 3460 to 3464 (1991)).

Addition of a metal oxide solubilizer to the metal polishing liquid is said to be effective for increasing the polishing rate of CMP. It is believed that solubilization of the metal oxide particles separated by polishing with the abrasive particles (hereinafter, referred to as etching) in the polishing liquid is effective for improving polishing efficiency of the abrasive particles. Although addition of the metal oxide solubilizer leads to increase in the polishing rate of CMP, it may also lead to etching of the oxidized layer on the metal film surface in concave parts and exposure of the metal film surface, which in turn leads to further oxidation of the metal film surface by the oxidizing agent, and finally to progress of etching of the metal film in the concave parts when such actions are repeated. As a result, it leads to a phenomenon of bending like dish in the central surface area of the metal wiring embedded after polishing (hereinafter, referred to as dishing), damaging the flatness of the surface.

For prevention thereof, a protective film-forming agent is added to the metal-polishing liquid. The protective film-forming agent gives a protective film formed on the oxidized layer of the metal film surface, preventing etching of the oxidizedlayer. The protective film is desirably removed easily by the abrasive particles without deterioration in CMP polishing rate.

For control of dishing and etching of the metal film and for forming of high-reliability LSI wiring, a method of using a CMP polishing liquid comprising a metal oxide solubilizer such as aminoacetic acid and/or amidosulfuric acid and the protective film-forming agent such as benzotriazole. The method is described, for example, in Japanese Patent No. 3397501.

On the other hand, for prevention of diffusion of the metal into the interlayer insulation film and improvement in adhesion, a layer of a conductive material such as tantalum, a tantalum alloy, or tantalum nitride is formed as a barrier conductor layer (hereinafter, referred to also as barrier layer) as the underlayer of the wiring metal such as copper or copper alloy. It is thus necessary to remove the exposed barrier layer by CMP, in the area other than that where a wiring metal such as copper or copper alloy is embedded. However, the conductive material for the barrier layer is harder than copper or the copper alloy; even when an abrasive for the copper or the copper alloy is used in combination, it is not possible to obtain sufficiently high polishing rate; and the polished surface often becomes rather irregular. For that reason, studied was a two-step polishing method of carrying out a first chemical mechanical polishing step of polishing the wiring metal and a second chemical mechanical polishing step of polishing the barrier layer.

In the second chemical mechanical polishing step of polishing the barrier layer, it is needed to polish also the interlayer insulation film, for improvement in flatness of the polished surface. The interlayer insulation film has been mainly a silicon oxide film, but recently, use of a silicon-based material or organic polymer having a dielectric constant lower than that of silicon oxide film is studied for improvement in performance of LSI's (see e.g., Japanese Patent Application Laid-Open No. 2001-049184).

When a first chemical mechanical polishing step of polishing a conductive substance layer of a substrate having an interlayer insulation film containing convex and concave regions on the surface thereof, a barrier layer coating a surface of the interlayer insulation film, and the conductive substance layer coating the barrier layer while filling the concave regions, and thus exposing the barrier layer in the convex regions is carried out, the dishing occurs more frequently in a patterned area on the substrate, wherein the width of the wiring metal region is relatively larger than the width of the interlayer insulation film region, so-called patterned area having high-density of the wiring metal regions (e.g., stripe-shaped patterned area having wiring metal regions having a width of 90µm and the interlayer insulation film regions having a width of 10 µm that are aligned alternately) than in a patterned area on the substrate, wherein the width of the wiring metal regions is relatively smaller than the with of the interlayer insulation film regions, i.e., so-called patterned area having low-density of the wiring metal regions, (e.g., stripe-shaped patterned area having wiring metal regions having a width of 100 µm and interlayer insulation film regions having a width of 100 µm that are aligned alternately). If dishing occurs, the interlayer insulation film regions in the patterned area having high-density of the wiring metal regions become easily convex than the wiring metal regions.

After completion of the first chemical mechanical polishing step, a second chemical mechanical polishing step is performed to expose the interlayer insulation film in the convex regions by means of polishing the barrier layer by using a conventionally known metal-film polishing liquid. In the second chemical mechanical polishing step, recommended for prevention of the scratches by polishing is a method of polishing with a soft polishing pad, i.e., a commercially available black suede-like wet-expanded polyurethane pad, Supreme RN-H Politex (manufactured by Rohm & Haas). However, if the interlayer insulation film regions in the patterned area having high-density of the wiring metal regions are pressed by the soft polishing pad, the narrow interlayer insulation film regions that become more convex by the generation of dishing than the wiring metal regions are brought into contact with the polishing pad. The patterned area having high-density of the wiring metal regions is polished under greater force than the field area and the patterned area having low-density of the wiring metal regions, thus giving a certain difference of the polishing amount between the polishing amount of the interlayer insulation film in the patterned area having high-density of the wiring metal regions and the polishing amount of the interlayer insulation film in the field area (hereinafter, referred to as erosion), which in turn leads to deterioration in flatness of the polished surface and generation of surface level difference on the wiring structure substrate, unfavorablycausingaproblemof difficulty of satisfying the requirement in high flatness that is needed for production of highly reliable and high-performance semiconductor devices that essentially demand formation of fine wiring.

An object of the present invention, which was made under the circumstances above, is to provide a CMP polishing liquid that reduces the erosion, as the pressure applied to the patterned area having high-density of wiring metal regions and the polishing pad is reduced in the second chemical mechanical polishing step.

Another object of the present invention is to provide a polishing method for use in production of semiconductor devices and others that gives polished articles superior in fineness, thinness and dimensional accuracy, higher in reliability and lower in cost.

### SUMMARY OF THE INVENTION

The present invention relates to (1) a CMP polishing liquid being capable of using in a chemical mechanical polishing step comprising of: a first chemical mechanical polishing step of polishing a conductive substance layer of a substrate having an interlayer insulation film containing convex and concave regions on the surface thereof, a barrier layer coating along the surface of the interlayer insulation film, and a conductive substance layer coating the barrier layer while filling the concave regions, and thus exposing the barrier layer in the convex regions; and a second chemical mechanical polishing step of exposing the interlayer insulation film in the convex regions by polishing the barrier layer exposed in the first chemical mechanical polishing step by means of rotating a surface plate and the substrate relatively to each other in the state that the substrate is pressed onto a polyurethane wet-expanded polishing pad under pressure, while the polishing liquid is supplied to a space between the pad and the substrate;
wherein the CMP polishing liquid is characterized in that a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1,000 µm or more of the interlayer insulation film region formed on the substrate is polished to a depth of 400 Å or more.

The present invention also relates to (2) the CMP polishing liquid according to (1) above, containing an additive having an action to reduce the difference (B) - (A) of polishing amount.

The present invention also relates to (3) the CMP polishing liquid according to (2) above, wherein the additive is an organic solvent.

The present invention also relates to (4) the CMP polishing liquid according to (2) above, wherein the additive is a water-soluble polymer having a weight-average molecular weight of 500 or more.

The present invention also relates to (5) the CMP polishing liquid according to (2) above, wherein the additive contains an organic solvent and a water-soluble polymer having a weight-average molecular weight of 500 or more.

The present invention also relates to (6) the CMP polishing liquid according to (3) or (5) above, wherein the organic solvent is at least one solvent selected from glycol monoethers, ketones and alcohols.

The present invention also relates to (7) the CMP polishing liquid according to (3), (5) or (6) above, wherein the organic solvent is at least one solvent selected from diols.

The present invention also relates to (8) the CMP polishing liquid according to (4) or (5), above wherein the water-soluble polymer is at least one polymer selected from polysaccharides, polycarboxylic acids, polycarboxylic esters, polycarboxylic acid salts and vinyl polymers.

The present invention also relates to (9) the CMP polishing liquid according to any one of (1) to (8) above, containing abrasive particles and water.

The present invention also relates to (10) the CMP polishing liquid according to (9) above, wherein the abrasive particles are at least one abrasive particle selected from silica, alumina, ceria, titania, zirconia and germania.

The present invention also relates to (11) the CMP polishing liquid according to any one of (1) to (10) above, containing a metal oxide solubilizer.

The present invention also relates to (12) the CMP polishing liquid according to (11) above, wherein the metal oxide solubilizer is at least one compound selected fromorganic acids, organic esters, organic acid ammonium salts and inorganic acids.

The present invention also relates to (13) the CMP polishing liquid according to any one of (1) to (12) above, containing a metal anticorrosive.

The present invention also relates to (14) the CMP polishing liquid according to (13) above, wherein the metal anticorrosive is at least one compound selected from triazole skeleton-containing compounds, pyrazole skeleton-containing compounds, pyrimidine skeleton-containing compounds, imidazole skeleton-containing compounds, guanidine skeleton-containing compounds and thiazole skeleton-containing compounds.

The present invention also relates to (15) the CMP polishing liquid according to any one of (1) to (14) above, containing a metal-oxidizing agent.

The present invention also relates to (16) the CMP polishing liquid according to (15) above, wherein the metal-oxidizing agent is at least one compound selected from hydrogen peroxide, nitric acid, potassium periodate, hypochlorous acid and ozone water.

The present invention also relates to (17) a polishing method, characterized by including a first chemical mechanical polishing step of polishing a conductive substance layer of a substrate having an inter layer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and a second chemical mechanical polishing step of exposing the interlayer insulation film in the convex regions by polishing the barrier layer exposed in the first chemical mechanical polishing step by using the CMP polishing liquid according to any one of Claims 1 to 16.

The present invention also relates to (18) the polishing methodaccordingto (17) above, wherein the interlayer insulation film is a silicon-based film or an organic polymer film.

The present invention also relates to (19) the polishing method according to (17) or (18), wherein the conductive substance is at least one compound selected from copper, copper alloys, copper oxides and copper alloy oxides.

The present invention also relates to (20) the polishing method according to any one of (17) to (19) above, wherein the barrier layer contains at least one compound selected from tantalum, tantalum compounds, titanium, titanium compounds, tungsten, tungsten compounds, ruthenium and ruthenium compounds.

The present invention also relates to (21) a polishing method, including a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and a second chemical mechanical polishing step of exposing the interlayer insulation film in the convex regions by polishing the barrier layer exposed in the first chemical mechanical polishing step by means of rotating the surface plate and the substrate relatively to each other, in the state that the substrate is pressed onto a polyurethane wet-expanded polishing pad under pressure, while a polishing liquid is supplied to the space between a pad and the substrate;
characterized in that a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1,000 µm or more of the interlayer insulation film region formed on the substrate is polished to a depth of 400 Å or more.

By using the CMP polishing liquid according to the present invention, it is possible to reduce the erosion, i.e., to make the surface level difference on the wiring structure substrate smaller and obtain high flatness, because the interlayer insulation films in the patterned area having low-density of the wiring metal regions, in the patterned area having high-density of the wiring metal regions and also in the field area are polished similarly.

In addition, the polishing method of performing chemical mechanical polishing by using the CMP polishing liquid according to the present invention is higher in productivity, gives polished articles superior in fineness, thinness, dimensional accuracy and electric properties, and thus, is favorable for use in production of high-reliability semiconductor and other electronic devices.

### BEST MODE OF CARRYING OUT THE INVENTION

The CMP polishing liquid according to the present invention is a CMP polishing liquid being capable of using in a chemical mechanical polishing step consisting of: a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and a second chemical mechanical polishing step of exposing the interlayer insulation film in the convex regions by polishing the barrier layer exposed in the first chemical mechanical polishing step by means of rotating a surface plate and the substrate relatively to each other, in the state that the substrate is pressed onto a polyurethane wet-expanded polishing pad under pressure, while a polishing liquid is supplied to a space between the pad and the substrate;
wherein the CMP polishing liquid is characterized in that a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1,000 µm or more of the interlayer insulation film region formed on the substrate is polished to a depth of 400 Å or more.

The CMP polishing liquid according to the present invention, when it contains an additive having an action to reduce the difference (B)-(A) of polishing amount (hereinafter, referred to as additive), allows reduction of the pressure applied to the interlayer insulation film regions in the patterned area having high-density of the wiringmetal regions and the polishing pad, thus making the erosion smaller.

The additive preferably contains at least one compound selected from organic solvents and water-soluble polymer having a weight-average molecular weight of 500 or more, more preferably contains both an organic solvent and a water-soluble polymer having a weight-average molecular weight of 500 or more.

Examples of the organic solvents used as additives include glycols such as ethylene glycol, propylene glycol, diethylene glycol, dipropylene glycol, triethylene glycol, and tripropylene glycol; glycol monoethers such as ethylene glycol monomethylether, propylene glycol monomethylether, diethylene glycol monomethylether, dipropylene glycol monomethylether, triethylene glycol monomethylether, tripropylene glycol monomethylether, ethylene glycol monoethylether, propylene glycol monoethylether, diethylene glycol monoethylether, dipropylene glycol monoethylether, triethylene glycol monoethylether, tripropylene glycol monoethylether, ethylene glycol monopropylether, ethylene glycol monophenylether, propylene glycol monopropylether, diethylene glycol monopropylether, dipropylene glycol monopropylether, triethylene glycol monopropylether, tripropylene glycol monopropylether, ethylene glycol monobutylether, propylene glycol monobutylether, diethylene glycol monobutylether, dipropylene glycol monobutylether, triethylene glycol monobutylether, and tripropylene glycol monobutylether; glycol diethers such as ethylene glycol dimethylether, propylene glycol dimethylether, diethylene glycol dimethylether, dipropylene glycol dimethylether, triethylene glycol dimethylether, tripropylene glycol dimethylether, ethylene glycol diethylether, propylene glycol diethylether, diethylene glycol diethylether, dipropylene glycol diethylether, triethylene glycol diethylether, tripropylene glycol diethylether, ethylene glycol dipropylether, propylene glycol dipropylether, diethylene glycol dipropylether, dipropylene glycol dipropylether, triethylene glycol dipropylether, tripropylene glycol dipropylether, ethylene glycol dibutylether, propylene glycol dibutylether, diethylene glycol dibutylether, dipropylene glycol dibutylether, triethylene glycol dibutylether, and tripropylene glycol dibutylether; alcohols such as methanol, ethanol, propanol, n-butanol, n-pentanol, n-hexanol, isopropanol, 3-methyl-1-butanol, 2-methyl-1-butanol, benzylalcohol, 2-phenyl-1-ethanol, 2-phenoxyethanol, 2-ethyl-1,3-hexanediol, 2-butyl-2-ethyl-1,3-propanediol, 2,2-dimethyl-1,3-propanediol, 2-hydroxymethyl-2-methyl-1,3-propanediol, 3-mercapto-1,2-propanediol, 3-(o-methoxyphenoxy)-1,2-propanediol, 1,3-propanediol, 1,2,3-trihydroxybenzene, pentaerythritol, 2,5-dimethyl-2,5-hexanediol, 1,6-hexanediol, 2-methyl-2,4-pentanediol, 2,2,4-trimethyl-1,3-pentanediol, 3,6-dithia-1,8-octanediol, and cyclohexanol; ketones such as acetone, methylethylketone, cyclohexanone, cyclopentanone, and cyclohexyl acetate; carbonic acid esters such as ethylene carbonate, propylene carbonate, dimethyl carbonate, diethyl carbonate, and methylethyl carbonate; lactones such as butylolactone and propylolactone; ethers such as tetrahydrofuran, dioxane, dimethoxyethane, polyethyleneoxide, ethylene glycol monomethyl acetate, diethylene glycol monoethylether acetate, and propylene glycol monomethylether acetate; as well as phenol, dimethylformamide, n-methylpyrrolidone, ethyl acetate, ethyl lactate, sulfolane and the like. Among them, glycol monoethers, ketones, alcohols, and the like are preferable, and ethylene glycol monomethylether, propylene glycol monomethylether, ethylene glycol monoethylether, propylene glycol monoethylether, ethylene glycol monopropylether, ethylene glycol monophenylether, propylene glycol monopropylether, ethylene glycol monobutylether, propylene glycol monobutylether, 3-methyl-1-butanol, 2-methyl-1-butanol, 2-ethyl-1,3-hexanediol, 2-butyl-2-ethyl-1,3-propanediol, 2,2-dimethyl-1,3-propanediol, 2-hydroxymethyl-2-methyl-1,3-propanediol, 3-mercapto-1,2-propanediol, 3-(o-methoxyphenoxy)-1,2-propanediol, 1,3-propanediol, 2,5-dimethyl-2,5-hexanediol, 1,6-hexanediol, 2-methyl-2,4-pentanediol, 2,2,4-trimethyl-1,3-pentanediol, 3,6-dithia-1,8-octanediol, cyclohexanol, methylethylketone, cyclohexanone, cyclopentanone, cyclohexyl acetate, and the like are more preferable, and diols such as 2-ethyl-1, 3-hexanediol, 2-butyl-2-ethyl-1,3-propanediol, 2,2-dimethyl-1,3-propanediol, 2-hydroxymethyl-2-methyl-1,3-propanediol, 3-mercapto-1,2-propanediol, 3-(o-methoxyphenoxy)-1,2-propanediol, 1,3-propanediol, 2,5-dimethyl-2,5-hexanediol, 1,6-hexanediol, 2-methyl-2,4-pentanediol, 2,2,4-trimethyl-1,3-pentanediol, and 3,6-dithia-1,8-octanediol and the like are even more preferable.

The blending amount of the organic solvent in the CMP polishing liquid according to the present invention is preferably 0.1 to 80 g, more preferably 0.2 to 40 g, and particularly preferably 0.5 to 20 g, with respect to 100 g of the CMP polishing liquid. When the amount of the organic solvent is less than 0.1 g, a wettability of the CMP polishing liquid to substrate tends to be deteriorated, while when the amount of the organic solvent is more than 80 g, a risk of ignition which is unfavorable in production tends to be higher.

The weight-average molecular weight of the water-soluble polymer used as an additive is preferably 500 or more, more preferably 1, 500 or more, and particularly preferably 5, 000 or more. The upper limit of the weight-average molecular weight of the water-soluble polymer is not particularly limited, but is preferably 5, 000, 000 or less, from the viewpoint of solubility. When the weight-average molecular weight of the water-soluble polymer is less than 500, a high polishing rate tends to be not obtainable.

The weight-average molecular weight of the water-soluble polymer can be determined by gel permeation chromatography, by using a calibration curve drawn with standard polystyrene samples.

The water-soluble polymer having a weight-average molecular weight of 500 or more used as an additive is not particularly limited, and examples thereof include polysaccharides such as alginic acid, pectin acid, carboxymethylcellulose, agar, curdlan and pullulan; polycarboxylic acids ,the esters and salts thereof such as polyaspartic acid, polyglutamic acid, polylysine, polymalic acid, polymethacrylic acid, ammonium polymethacrylate salt, sodium polymethacrylate salt, polyamide acid, polymaleic acid, polyitaconic acid, polyfumaric acid, poly(p-styrenecarboxylic acid), polyacrylic acid, polyacrylamide, aminopolyacrylamide, ammoniumpolyacrylate salt, sodiumpolyacrylate salt, polyamide acid, polyamide acid ammonium salt, polyamide acid sodium salt andpolyglyoxylic acid, ; vinyl polymers such as polyvinylalcohol, polyvinylpyrrolidone and polyacrolein; and the like. Among them, polycarboxylic acids are preferable, and polyacrylic acid is more preferable. These compounds may be used alone or as a mixture of two or more thereof.

In the case when the substrate to be processed with the CMP polishing liquid according to the present invention is, for example, a silicon substrate for semiconductor integrated circuit, any contamination with alkali metal, alkali-earth metal, halide or the like is undesirable, thus, the water-soluble polymer containing no alkali metal, alkali-earthmetal, or halide is preferred; and therefore, pectin acid, agar, polymalic acid, polymethacrylic acid, polyacrylic acid, ammonium polyacrylate salt, polyacrylamide, polyvinylalcohol and polyvinylpyrrolidone, or the esters or ammonium salts thereof are particularly preferable. However, the water-soluble polymer containing alkali metal, alkali-earth metal, or halide may be used when the substrate is for example a glass substrate.

The blending amount of the water-soluble polymer having a weight-average molecular weight of 500 or more in the CMP polishing liquid according to the present invention is preferably 10 g or less, more preferably 0.005 to 5 g, and particularly preferably 0.01 to 2 g, with respect to 100 g of the CMP polishing liquid. When the amount of the water-soluble polymer is more than 10 g, the polishing rate tends to be decreased.

The CMP polishing liquid according to the present invention may contain abrasive particles and water. Examples of the abrasive particles include inorganic abrasive particles such as of silica, alumina, zirconia, ceria, titania, germania, silicon carbide and the like, organic abrasive particles such as of polystyrene, polyacryl, polyvinyl chloride and the like. Among them, silica, alumina, zirconia, ceria, titania, and germania are preferable, and silica or alumina is particularly preferable. Among silica or alumina, colloidal silica or colloidal alumina having an average diameter of 70 nm or less, which is superior in dispersion stability in the CMP polishing liquid and thus leads to fewer polishing scratches (scratching) caused by CMP, is preferable, and colloidal silica or colloidal alumina having an average diameter of 40 nm or less is more preferable. These abrasive particles may be used alone or as a mixture of two or more.

The abrasive particles are preferably agglomerated particles of primary particles; agglomerated particles containing an average of two particles or less are preferable; and agglomerated particles having an average of less than 1.2 particles are particularly preferable.

In addition, the standard deviation of average particle size distribution of the abrasive particles is preferably 10 nm or less, more preferably 5 nm or less.

The colloidal silica can be produced by a known method, for example by hydrolysis of an silicon alkoxide or ion exchange of sodium silicate, and methods of hydrolyzing an silicon alkoxide such as tetramethoxysilane or tetraethoxysilane are used most frequently, because of easiness in controlling the particle size and alkali metal impurities. The colloidal alumina can also be produced by a known method of hydrolyzing aluminum nitrate.

The blending amount of the abrasive particles in the CMP polishing liquid according to the present invention is preferably 0.01 to 50 g, more preferably 0.02 to 30 g, and particularly preferably 0.05 to 15 g, with respect to 100 g of the CMP polishing liquid. A blending amount of the abrasive particles at less than 0.01 g may lead to deterioration in polishing rate, while a blending amount of more than 50 g, to more frequent polishing scratching.

The CMP polishing liquid according to the present invention may contain a metal oxide solubilizer. The metal oxide solubilizer is not particularly limited, and examples thereof include organic acids, organic esters, organic acid ammonium salts, inorganic acids, inorganic acid ammonium salts, and the like. Among them, formic acid, malonic acid, malic acid, tartaric acid, citric acid, salicylic acid, adipic acid, and phthalic acid are preferable, and malic and salicylic acids are more preferable, for controlling etching velocity effectively while preserving its practical CMP velocity. Sulfuric acid is also preferable, because high CMP velocity is obtained. These solubilizers may be used alone or as a mixture of two or more.

The blending amount of the metal oxide solubilizer in the CMP polishing liquid according to the present invention is preferably 0,001 to 20 g, more preferably 0.002 to 10 g, and particularly preferably 0.005 to 5 g, with respect to 100 g of the CMP polishing liquid. A blending amount of metal oxide solubilizer at less than 0. 001 g may lead to decrease of polishing rate, while a blending amount of more than 20 g makes it more difficult to control etching, leading to roughening of the polished face.

The CMP polishing liquid according to the present invention may contain a metal anticorrosive. The metal anticorrosive is not particularly limited, and examples thereof include triazole skeleton-containing compounds, pyrazole skeleton-containing compounds, pyrimidine skeleton-containing compounds, imidazole skeleton-containing compounds, guanidine skeleton-containing compounds, thiazole skeleton-containing compounds and the like. Examples of the triazole skeleton-containing compounds include 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxyl(-1H-)benzotriazole, 4-carboxyl(-1H-)benzotriazole methyl ester, 4-carboxyl(-1H-)benzotriazole butyl ester, 4-carboxyl(-1H-)benzotriazole octyl ester, 5-hexylbenzotriazole, [1,2,3-benzotriazolyl-1-methyl][1,2,4-triazolyl-1-methyl][2 -ethylhexyl]amine, tolyltriazole, naphthotriazole, bis[ (1-benzotriazolyl)methyl]phosphonic acid, and the like. Examples of the pyrazole skeleton-containing compounds include 3,5-dimethylpyrazole, 3-methyl-5-pyrazolone, 3-amino-5-methylpyrazole, 3-amino-5-hydroxypyrazole, 3-amino-5-methylpyrazole and the like. Examples of the pyrimidine skeleton-containing compounds include pyrimidine, 1,2,4-triazolo[1,5-a]pyrimidine, 1,3,4,6,7,8-hexahydro-2H-pyrimido[1,2-a]pyrimidine, 1,3-diphenyl-pyrimidine-2,4,6-trione, 1,4,5,6-tetrahydropyrimidine, 2,4,5,6-tetraaminopyrimidine sulfate, 2,4,5-trihydroxypyrimidine, 2,4,6-triaminopyrimidine, 2,4,6-trichloropyrimidine, 2,4,6-trimethoxypyrimidine, 2,4,6-triphenylpyrimidine, 2,4-diamino-6-hydroxylpyrimidine, 2,4-diaminopyrimidine, 2-acetamidopyrimidine, 2-aminopyrimidine, 2-methyl-5,7-diphenyl-(1,2,4)triazolo(1,5-a)pyrimidine, 2-methylsulfanilyl-5,7-diphenyl-(1,2,4) triazolo(1,5-a)pyrimidine, 2-methylsulfanilyl-5,7-diphenyl-4,7-dihydro-(1,2,4)triazolo (1,5-a) pyrimidine, 4-aminopyrazolo[3,4-d]pyrimidine and the like. Examples of the imidazole skeleton-containing compounds include imidazole, 2-methylimidazole, 2-ethylimidazole, 2-isopropylimidazole, 2-propylimidazole, 2-butylimidazole, 4-methylimidazole, 2,4-dimethylimidazole, 2-ethyl-4-methylimidazole, 2-aminoimidazole, mercaptobenzimidazole and the like. Examples of the guanidine skeleton-containing compounds include 1,3-diphenylguanidine, 1-methyl-3-nitroguanidine and the like. Examples of the thiazole skeleton-containing compounds include 2-aminothiazole, 4,5-dimethylthiazole, 2-amino-2-thiazoline, 2,4-dimethylthiazole, 2-amino-4-methylthiazole and the like. Among them, triazole skeleton-containing compounds are preferable, and benzotriazole is particularly preferable. In addition, these metal anticorrosives may be used alone or as a mixture of two or more.

The blending amount of the metal anticorrosive in the CMP polishing liquid according to the present invention is preferably 10 g or less, more preferably 0.001 to 5 g, and particularly preferably 0.002 to 2 g, with respect to 100 g of the CMP polishing liquid. A metal anticorrosive blending amount of more than 10 g leads to decrease of polishing rate.

The CMP polishing liquid according to the present invention may contain a metal-oxidizing agent. The metal-oxidizing agent is not particularly limited, and examples thereof include hydrogen peroxide, nitric acid, potassium periodate, hypochlorous acid, ozone water and the like. Among them, hydrogen peroxide is particularly preferable. These compounds may be used alone or as a mixture of two or more.

In the case when the substrate to be processed with the CMP polishing liquid according to the present invention is, for example, a silicon substrate for semiconductor integrated circuit, any contamination with alkali metal, alkali-earth metal, halide or the like is undesirable, thus, an oxidizing agent containing no nonvolatile component is desirable. Because ozone water significantly changes its composition over time, hydrogen peroxide is most suitable. Alternatively the oxidizing agent containing nonvolatile component may be used when the substrate to be processed is, for example, a glass substrate having no semiconductor element.

The blending amount of the metal-oxidizing agent in the CMP polishing liquid according to the present invention is preferably 0.01 to 50 g, more preferably 0.02 to 20 g, and particularly preferably 0.05 to 10 g, with respect to 100 g of the CMP polishing liquid. A blending amount of the metal-oxidizing agent at less than 0.01 g may lead to insufficient oxidation of metal and decrease of CMP polishing rate, while a blending amount of more than 50 g to roughening of the polished face.

By carrying out the second chemical mechanical polishing step by using the CMP polishing liquid according to the present invention as a polishing liquid and a polyurethane wet-expanded polishing pad as a polishing pad, when the interlayer insulation film in a field area having a width of 1,000 µm or more of the interlayer insulation film region formed on the substrate is polished to a depth of 400 Å or more, it is possible to make the difference (B)-(A) of polishing amount between the polishing amount (A) of the interlayer insulation film in the field area and the polishing amount (B) of the interlayer insulation film in the stripe-shaped patterned area having a total width of 1, 000 µm or more wherein the wiring metal region having a width of 90 µm and the interlayer insulation film region having a width of 10 µm are aligned alternately on the substrate, 650 Å or less and thus to decrease erosion. The field area is an area having a width of 1,000 µm or more where no wiring metal region is present, i.e., where there is only an interlayer insulation film region.

The polishing method according to the present invention is characterized by including a first chemical mechanical polishing step of polishing the conductive substance layer of a substrate having an interlayer insulation film containing convex and concave regions on the surface thereof, a barrier layer coating along the surface of the interlayer insulation film, and a conductive substance layer coating the barrier layer while filling the concave regions, and thus exposing the barrier layer in the convex regions and a second chemical mechanical polishing step of exposing the interlayer insulation film in the convex regions by polishing the barrier layer exposed in the first chemical mechanical polishing step by using the CMP polishing liquid according to the present invention.

The polishing in the chemical mechanical polishing step is performed, for example, by a method of polishing the face to be polished, by rotating a surface plate and the substrate relatively to each other in the state where the substrate having a face to be polished is pressed onto the polishing pad placed on the polishing surface plate under force, while a polishing liquid is supplied into the space between the polishing pad and the substrate.

Examples of the conductive substances include conductive substances mainly containing a metal such as copper, copper alloys, copper oxides, copper alloy oxides, tungsten, tungsten alloys, silver, gold and the like. Among them, conductive substances containing copper as the main component such as copper, copper alloys, copper oxides, and copper alloy oxides are preferable. A film carrying the substance deposited by a known sputtering or plating method may be used as the conductive substance layer.

The barrier layer is formed for prevention of diffusion of the conductive substance into the interlayer insulation film and for improvement of the adhesion between the interlayer insulation film and the conductive substance. The material for the barrier layer is preferably selected from tungsten compounds such as tungsten, tungsten nitrides, and tungsten alloys; titanium compounds such as titanium, titanium nitrides, and titanium alloys; tantalum compounds such as tantalum, tantalum nitrides, and tantalum alloys; ruthenium and ruthenium compounds. The barrier layer may have a single layer structure of this material or a two- or more-layered laminate structure.

Examples of the interlayer insulation films include silicon-based films and organic polymer films. Examples of the silicon-based films include silica-based films such as of silicon dioxide, fluorosilicate glass, organosilicate glass that is produced from trimethylsilane or dimethoxydimethylsilane as the starting material, silicon oxynitride, and hydrogenated silsesquioxane, as well as films of silicon carbide and silicon nitride. The organic polymer film is, for example, a low-dielectric wholly aromatic interlayer insulation film. Among them, an organosilicate glass is preferable. The film is formed by CVD, spin coating, dip coating, or spraying. Typical examples of the interlayer insulation films include interlayer insulation films formed during LSI production process, in particular in multilayer wiring process, and the like.

As the polishing apparatus for use in the polishing method according to the present invention, for example in the case of polishing with a polishing pad, a common polishing apparatus having a holder for holding the substrate to be polished and a polishing surface plate connected for example to a rotational frequency-variable motor, to which the polishing pad is attached, is used favorably. The polishing pad is used a soft wet-expanded polyurethane polishing pad and the preferable pad having a Shore hardness (D scale) of 40 or less. A commercially available black suede-like wet-expanded polyurethane pad, Supreme RN-H Politex (manufactured by Rohm & Haas), is used favorably.

The polishing condition is not particularly limited, but the rotational rate of the surface plate is preferably lower at 200 min⁻¹ or less, for prevention of the substrate from centrifugal separation.

The pressure applied to the semiconductor substrate having a face to be polished against the polishing cloth is preferably 1 to 100 kPa, more preferably 5 to 50 kPa, for ensuring uniformity of the polishing rate on the face to be polished and flatness of the pattern obtained.

The CMP polishing liquid according to the present invention is supplied continuously to the polishing pad during polishing, for example, by a pump. The feed rate is not particularly limited, but the surface of the polishing pad is preferably covered always with the polishing liquid.

Preferably, the substrate after polishing is washed thoroughly with running water and the water droplets remaining on the substrate removed for example by spin drying before drying.

The polishing pad is preferably processed in an additional conditioning step before polishing, for performing chemical mechanical polishing with a polishing pad in the same surface state. The polishing pad is conditioned, for example, by spraying the polishing pad with a liquid at least containing water. The polishing method according to the present invention is then carried out, and further, an additional substrate cleaning step is carried out preferably.

In the second chemical mechanical polishing step in the polishing method according to the present invention, by exposing the interlayer insulation film in the convex regions by polishing the barrier layer exposed in the first chemical mechanical polishing step, by means of rotating the surface plate and the substrate relatively to each other in the state that the substrate is pressed onto the polyurethane wet-expanded polishing pad under pressure while supplying the CMP polishing liquid according to the present invention into the space between the pad and the substrate, when the interlayer insulation film in a field area having a width of 1, 000 µm or more of the interlayer insulation film region formed on the substrate is polished to a depth of 400 Å or more, it is possible to make the difference (B)-(A) of polishing amount between the polishing amount (A) of the interlayer insulation film in the field area and the polishing amount (B) of the interlayer insulation film in the stripe-shaped patterned area having a total width of 1, 000 µm or more wherein the wiring metal region having a width of 90 µm and the interlayer insulation film region having a width of 10 µm are aligned alternately on the substrate, 650 Å or less and thus to decrease erosion.

The polishing method according to the present invention can be applied, for example, to preparation of wiring layers in semiconductor devices.

Hereinafter, the polishingmethod according to the present invention will be described, taking formation of a wiring layer in a semiconductor device as an example.

First, an interlayer insulation film for example of silicon dioxide is formed on a silicon substrate. Then, by a known means such as resist layer formation or etching, concave regions (substrate-exposed regions) are formed in a desired pattern on the interlayer insulation film surface, giving an interlayer insulation film having convex and concave regions. A barrier layer for example of tantalum coating the interlayer insulation film is formed, for example by vapor deposition or CVD, on the interlayer insulation film along the surface irregularity.

Additionally, a conductive substance layer for example of copper coating the barrier layer and filling the concave regions is formed for example by vapor deposition, plating or CVD. Preferably, the thickness of the interlayer insulation film formed on the substrate is approximately 0.01 to 2.0 µm, the thickness of the barrier layer is approximately 1 to 100 nm, and the thickness of the conductive substance layer is approximately 0.01 to 2.5 µm.

Then, the conductive substance layer on the surface of the substrate is polished by CMP for example by using a CMP polishing liquid for the conductive substance layer having sufficiently high polishing rate ratio of the conductive substance layer/barrier layer (the first chemical mechanical polishing step). A substrate having a desired conductor pattern, in which the barrier layer in the convex regions on the substrate is exposed in this way and the conductive substance layer remains in the concave regions, is obtained. During progress of the polishing, the conductive substance layer and part of the barrier layer in the convex regions may be polished simultaneously. The patterned face obtained after the first chemical mechanical polishing step is polished as the face to be polished in the second chemical mechanical polishing step, by using the CMP polishing liquid according to the present invention.

In the second chemical mechanical polishing step, the barrier layer exposed in the first chemical mechanical polishing step is polished by rotating the surface plate and the substrate relatively to each other in the state where the substrate is pressed on the polyurethane wet-expanded polishing pad under force, while the CMP polishing liquid according to the present invention is supplied into the space between the pad and the substrate. Because the CMP polishing liquid according to the present invention can polish the conductive substance, the barrier layer and the interlayer insulation film, at least the exposed barrier layer and the conductive substance layer in the concave regions are polished in the second polishing step.

When the interlayer insulation film under the barrier layer in the convex regions is exposed completely, the conductive substance layer, i.e., wiring layer, remains in the concave regions, and a desired pattern in which the cross section of the barrier layer is exposed at the boundary between the convex and concave regions is obtained, the polishing is terminated.

For ensuring favorable flatness of the filmafterpolishing, the film may be overpolished (e.g., if the period needed to obtain a desired pattern in the second chemical mechanical polishing step is 100 seconds, polishing for 100 seconds and additional 50 seconds is called 50% overpolishing) to a depth including part of the interlayer insulation film in the convex regions.

An interlayer insulation film and a 2nd metal wiring layer are formed on the metal wiring thus formed; an interlayer insulation film is formed additionally between and on the wirings, and the composite film is polished, forming a smooth face over the entire surface of the semiconductor substrate. It is possible, by repeating the steps, to produce a semiconductor device having a desired number of wiring layers.

The polishing liquid according to the present invention can be used, not only for polishing of such a metal film formed on a semiconductor substrate, but also for polishing of the substrates for magnetic head and others.

### EXAMPLES

Hereinafter, the present invention will be described with reference to Examples. It should be understood that the present invention is not restricted by these Examples.

### Examples 1 to 8, Comparative Examples 1 to 3

### (Method of preparing polishing liquid)

The raw materials shown in Tables 1 and 2 were blended in the composition shown therein, to give CMP polishing slurries used in Examples 1 to 8 and Comparative Examples 1 to 3. Polishing tests were performed by using these CMP polishing slurries under the following polishing condition:

### (Polishing of copper-patterned substrate)

Only protruding copper film on a copper wiring-patterned substrate (854CMP pattern, manufactured by ATDF: interlayer insulation film of silicon dioxide having a thickness of 5, 000Å) was polished by a known method, leaving the barrier layer in the convex regions exposed on the polished surface. The resultant substrate was used in the following polishing test. The barrier layer on the patterned substrate was a tantalum film having a thickness of 250Å.

### <Polishing condition>

Polishing apparatus: Single-sided CMP polishing apparatus (MIRRA, manufactured by Applied Materials)
Polishing pad: Suede-like wet-expanded polyurethane pad (Supreme RN-H Politex, manufactured by Rohm & Haas)
Polishing pressure: 2 psi (approximately 14 kPa)
Surface plate rotational frequency: 93 /min
Head rotational frequency: 87 /min
Polishing liquid feed rate: 200 ml/min

### <Substrate polishing step>

The patterned substrate was polished chemical mechanically by using each of the CMP polishing slurries prepared above under the polishing condition for 70 seconds. It corresponds to the second polishing step of the present invention, and all interlayer insulation film in the convex regions is exposed completely on the polished face in approximately 20 seconds, and the exposed interlayer insulation film in the convex regions was further polished for the remaining 50 seconds.

### <Substrate cleaning step>

A sponge brush (of a polyvinylalcohol resin) was pressed to the polished face of the patterned substrate after polishing, and the substrate and the sponge brush were rotated relatively to each other, while distilled water was supplied to the substrate, for cleaning for 90 seconds. The sponge brush was separated, and distilled water was supplied to the polished face of the substrate for 60 seconds. Finally, the substrate was rotated at high speed for centrifugal separation of distilled water, and then dried.

### <Evaluation items>

The patterned substrates thus cleaned were evaluated in the following tests (1) to (4), and the results are summarized in Tables 1 and 2.

### (1) Polishing amount (A) of interlayer insulation film in the field area:

The polishing amount of the interlayer insulation film in the field area (width: 1,000 µm) of patterned substrate was determined by measuring the film thickness after polishing by using a film thickness measurement system manufactured by Dainippon Screen Mfg., Co., Ltd. (product name: Lambda Ace VL-M8000LS) and calculating the difference thereof from the original thickness of the interlayer insulation film layer at 5000Å (5000-film thickness after polishing).

### (2) Polishing amount (B) of the interlayer insulation film in the patterned area having high-density of the wiring metal regions :

The polishing amount of the interlayer insulation film in the stripe-shaped patterned area having a total width of 3, 000 µm wherein the wiring metal region having a width of 90 µm and the interlayer insulation film region having a width of 10 µm are aligned alternately on the substrate, was determined by measuring the film thickness after polishing by using a film thickness measurement system manufactured by Dainippon Screen Mfg., Co., Ltd. (product name: Lambda Ace VL-M8000LS) and calculating the difference thereof from the original thickness of the interlayer insulation film layer at 5000Å (5000-film thickness after polishing).

### (3) Difference (B)-(A) of polishing amount (erosion amount):

The difference (B)-(A) of polishing amount between the polishing amount (B) of the interlayer insulation film in the patterned area having high-density of the wiring metal regions and the polishing amount (A) of the interlayer insulation film in the field area was calculated as an indicator of flatness.

### (4) Level difference:

The surface profile of the stripe-shaped patterned area having a total width of 3, 000 µm wherein the wiring metal region having a width of 100 µm and the interlayer insulation film region having a width of 100 µm that are aligned alternately on the substrate was analyzed by using a stylus profilometer, and the level difference thereof between in the interlayer insulation film region and in the wiring metal region was determined as an indicator of flatness.

**[Table 1]**

| | | Example | | | | | | | |
|---|---|---|---|---|---|---|---|---|---|
| Composition (wt parts) | | 1 | 2 | 3 | 4 | 5 | 6 | 7 | 8 |
| Abrasive particles | Silica particles *1 | 8 | 8 | 8 | 8 | 8 | 8 | 8 | 8 |
| Additives | 2-Ethyl-1,3-hexanediol | 2 | 0 | 0 | 0 | 0 | 2 | 0 | 0 |
| | Propylene glycol monopropylether | 0 | 2 | 0 | 0 | 0 | 0 | 2 | 0 |
| | Ethylene glycol monophenylether | 0 | 0 | 1 | 0 | 0 | 0 | 0 | 0 |
| | cyclohexanol | 0 | 0 | 0 | 1 | 0 | 0 | 0 | 0 |
| | Polyacrylic acid *2 | 0 | 0 | 0 | 0 | 0.1 | 0.1 | 0.1 | 0.1 |
| Metal oxide solubilizer | Malic acid | 0.5 | 0.5 | 0.5 | 0.5 | 0.5 | 0.5 | 0.5 | 0 |
| | Salicylic acid | 0 | 0 | 0 | 0 | 0 | 0 | 0 | 0.2 |
| | Phthalic acid | 0 | 0 | 0 | 0 | 0 | 0 | 0 | 0 |
| Metal anticorrosive | Benzotriazole | 0.1 | 0.1 | 0.1 | 0.1 | 0.1 | 0.1 | 0.1 | 0.1 |
| Oxidizing agent | Hydrogen peroxide | 0.5 | 0.5 | 0.5 | 0.5 | 0.5 | 0.5 | 0.5 | 0.5 |
| Water | | 88.9 | 88.9 | 89.9 | 89.9 | 90.8 | 88.8 | 88.8 | 89.1 |
| Polishing amount of interlayer insulation film (Å) | Polishing amount (A) in the field area | 460 | 500 | 410 | 460 | 420 | 440 | 420 | 450 |
| | Polishing amount (B) in the patterned area having high-density of the wiring metal regions | 1050 | 1100 | 1040 | 1080 | 970 | 940 | 770 | 1000 |
| | Difference (B)-(A) of polishing amount | 590 | 600 | 630 | 620 | 550 | 500 | 350 | 550 |
| Level difference(Å) | | 150 | 200 | 200 | 200 | 150 | 100 | 100 | 150 |

| | | | | | | | | | |
|---|---|---|---|---|---|---|---|---|---|
| *1: Colloidal silica particles having an average diameter of 60 nm *2: Polyacrylic acid having a weight-average molecular weight of 25,000 | | | | | | | | | |

**[Table 2]**

| | | Comparative Example | | |
|---|---|---|---|---|
| Composition (wt parts) | | 1 | 2 | 3 |
| Abrasive particles | Silica particles *1 | 8 | 8 | 8 |
| Additives | 2-Ethyl-1,3-hexanediol | 0 | 0 | 0 |
| | Propylene glycol monopropylether | 0 | 0 | 0 |
| | Ethylene glycol monophenylether | 0 | 0 | 0 |
| | cyclohexanol | 0 | 0 | 0 |
| | Polyacrylic acid *2 | 0 | 0 | 0 |
| Metal oxide solubilizer | Malic acid | 0.5 | 0 | 0 |
| | Salicylic acid | 0 | 0 | 0.2 |
| | Phthalic acid | 0 | 0.2 | 0 |
| Metal anticorrosive | Benzotriazole | 0.1 | 0.1 | 0.1 |
| Oxidizing agent | Hydrogen peroxide | 0.5 | 0.5 | 0.5 |
| Water | | 90.9 | 91.2 | 91.2 |
| Polishing amount of interlayer insulation film (Å) | Polishing amount (A) in the field area | 540 | 520 | 500 |
| | Polishing amount (B) in the patterned area having high-density of the wiring metal regions | 1310 | 1420 | 1350 |
| | Difference (B)-(A) of polishing amount | 770 | 900 | 850 |
| Level difference(Å) | | 300 | 600 | 950 |

| | | | | |
|---|---|---|---|---|
| *1: Colloidal silica particles having an average diameter of 60 nm *2: Polyacrylic acid having a weight-average molecular weight of 25,000 | | | | |

As shown in Tables 1 and 2, in Comparative Examples 1 to 3, when the interlayer insulation film in the field area was polished to a depth of 400 Å or more, the difference (B)-(A) of polishing amount (erosion amount) used as an indicator of flatness was 650 Å or more and the level difference was larger, indicating that a polished film with high flatness was not obtainable. In contrast in Examples 1 to 8, even when the interlayer insulation film in the field area was polished to a depth of 400 Å or more, the difference (B)-(A) of polishing amount of polishing amount (erosion amount) was 650 Å or less and the level difference was smaller, indicating that a polished film with high flatness was obtained after the second chemical mechanical polishing step.

## Claims

1. A CMP polishing liquid being capable of using in
a chemical mechanical polishing step comprising of:
a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and
a second chemical mechanical polishing step of exposing the interlayer insulation film in the convex regions by polishing the barrier layer exposed in the first chemical mechanical polishing step by means of rotating a surface plate and the substrate relatively to each other, in the state that the substrate is pressed onto a polyurethane wet-expanded polishing pad under pressure, while the polishing liquid is supplied to a space between the pad and the substrate;
wherein the CMP polishing liquid is **characterized in that** a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1, 000 µm or more of the interlayer insulation film region formed on the substrate is polished to a depth of 400 Å or more.

2. The CMP polishing liquid according to Claim 1, containing an additive having an action to reduce the difference (B)-(A) of polishing amount.

3. The CMP polishing liquid according to Claim 2, wherein the additive is an organic solvent.

4. The CMP polishing liquid according to Claim 2, wherein the additive is a water-soluble polymer having a weight-average molecular weight of 500 or more.

5. The CMP polishing liquid according to Claim 2, wherein the additive contains an organic solvent and a water-soluble polymer having a weight-average molecular weight of 500 or more.

6. The CMP polishing liquid according to Claim 3 or 5, wherein the organic solvent is at least one solvent selected from glycol monoethers, ketones and alcohols.

7. The CMP polishing liquid according to Claim 3, 5 or 6, wherein the organic solvent is at least one solvent selected from diols.

8. The CMP polishing liquid according to Claim 4 or 5, wherein the water-soluble polymer is at least one polymer selected from polysaccharides, polycarboxylic acids, polycarboxylic esters, polycarboxylic acid salts and vinyl polymers.

9. The CMP polishing liquid according to any one of Claims 1 to 8, containing abrasive particles and water.

10. The CMP polishing liquid according to Claim 9, wherein the abrasive particles are at least one abrasive particle selected from silica, alumina, ceria, titania, zirconia and germania.

11. The CMP polishing liquid according to any one of Claims 1 to 10, containing a metal oxide solubilizer.

12. The CMP polishing liquid according to Claim 11, wherein the metal oxide solubilizer is at least one compound selected from organic acids, organic esters, organic acid ammonium salts and inorganic acids.

13. The CMP polishing liquid according to any one of Claims 1 to 12, containing a metal anticorrosive.

14. The CMP polishing liquid according to Claim 13, wherein the metal anticorrosive at least one compound selected from triazole skeleton-containing compounds, pyrazole skeleton-containing compounds, pyrimidine skeleton-containing compounds, imidazole skeleton-containing compounds, guanidine skeleton-containing compounds and thiazole skeleton-containing compounds.

15. The CMP polishing liquid according to any one of Claims 1 to 14, containing a metal-oxidizing agent.

16. The CMP polishing liquid according to Claim 15, wherein the metal-oxidizing agent is at least one compound selected from hydrogen peroxide, nitric acid, potassium periodate, hypochlorous acid and ozone water.

17. A polishing method, **characterized by** including
a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions and
a second chemical mechanical polishing step of exposing the interlayer insulation film in the convex regions by polishing the barrier layer exposed in the first chemical mechanical polishing step by using the CMP polishing liquid according to any one of Claims 1 to 16.

18. The polishing method according to Claim 17, wherein the interlayer insulation film is a silicon-based film or an organic polymer film.

19. The polishing method according to Claim 17 or 18, wherein the conductive substance is at least one compound selected from copper, copper alloys, copper oxides and copper alloy oxides.

20. The polishing method according to any one of Claims 17 to 19, wherein the barrier layer contains at least one compound selected from tantalum, tantalum compounds, titanium, titanium compounds, tungsten, tungsten compounds, ruthenium and ruthenium compounds.

21. A polishing method including
a first chemical mechanical polishing step of polishing a conductive substance layer of a substrate having an interlayer insulation film containing convex and concave regions on a surface thereof, a barrier layer coating along the surface of the interlayer insulation film, and the conductive substance layer coating the barrier layer while filling the concave regions, and thus exposing the barrier layer in the convex regions; and
a second chemical mechanical polishing step of exposing the interlayer insulation film in the convex regions by polishing the barrier layer exposed in the first chemical mechanical polishing step by means of rotating a surface plate and the substrate relatively to each other, in the state that the substrate is pressed onto a polyurethane wet-expanded polishing pad under pressure, while a polishing liquid is supplied to a space between the pad and the substrate;
**characterized in that** a difference (B)-(A) is 650 Å or less ,
wherein the (A) is a polishing amount of the interlayer insulation film in a field area when the interlayer insulation film in the field area having a width of 1,000 µm or more of the interlayer insulation film region formed on the substrate is polished to a depth of 400 Å or more; and
the (B) is a polishing amount of the interlayer insulation film in a stripe-shaped patterned area having a total width of 1, 000 µm or more wherein a wiring metal region having a width of 90 µm and the interlayer insulation film region having a width of 10 µm are aligned alternately on the substrate when the interlayer insulation film in the field area having the width of 1,000 µm or more of the interlayer insulation film region formed on the substrate is polished to a depth of 400 Å or more.
